# EUROPEAN PATENT SPECIFICATION

(11) **EP 4 297 234 B1**
(45) Date of publication and mention of the grant of the patent: **11.11.2026**
(21) Application number: 22767555.0
(22) Date of filing: 11.03.2022
(51) Int. Cl.: H02J 7/00, G01R 31/36, G01R 19/165, G06F 1/26

(54) **ELECTRONIC DEVICE INCLUDING BATTERY PACK, AND OPERATION METHOD OF ELECTRONIC DEVICE**
ELEKTRONISCHE VORRICHTUNG MIT BATTERIEPACK UND BETRIEBSVERFAHREN FÜR DIE ELEKTRONISCHE VORRICHTUNG
DISPOSITIF ÉLECTRONIQUE COMPORTANT UN BLOC-BATTERIE ET PROCÉDÉ DE FONCTIONNEMENT DE DISPOSITIF ÉLECTRONIQUE

(30) Priority: 11.03.2021 KR 20210032215
(43) Date of publication of application: 27.12.2023
(73) Proprietor: Samsung Electronics Co., Ltd., Suwon-si, Gyeonggi-do 16677 (KR)
(72) Inventor: BAE, Chanjung, Suwon-si, Gyeonggi-do 16677 (KR); MOON, Sungsoo, Suwon-si, Gyeonggi-do 16677 (KR); JO, Jeonghoon, Suwon-si, Gyeonggi-do 16677 (KR); CHOI, Hangseok, Suwon-si, Gyeonggi-do 16677 (KR)
(74) Representative: Gulde & Partner
(86) International application number: PCT/KR2022/003449
(87) International publication number: WO 2022/191659

(56) References cited:
- JP-A- 2002 272 008
- KR-A- 20110 026 674
- US-A1- 2010 194 348
- US-A1- 2013 278 220
- US-A1- 2016 049 815

## Description

### [Technical Field]

An embodiment of the disclosure relate to an electronic device including a battery pack and a method of operating the electronic device.

### [Background Art]

In recent years, electronic devices have evolved into various forms for the convenience of users, and an electronic device may be implemented to have a battery pack inside it, which includes a battery supplying power to a system module.

Since the battery inside the electronic device supplies limited power to the system module, there is a need for a technique that may minimize the power consumption of the battery.

A technique of minimizing the power consumption of the battery includes a ship mode technique that minimizes the power consumption of the battery by disconnecting the battery from the system module in a power supply path.

US 2010194348 A1 discloses methods for waking up a battery system. US 2016049815 A1 discloses a method for controlling a state of a battery.

### [Detailed Description of the Invention]

### [Technical Problem]

In a ship mode technique, a ship mode may be performed under the control of a power supply module of a system module. The power supply module may control the ship mode by stopping power supply from a battery to a system, upon receipt of a specific command, and resuming the power supply through a specific operation, or may stop the power supply based on the voltage of a battery cell.

In the ship mode technique, the ship mode may not be performed depending on the structure of the power supply module. When the enabled ship mode is released (or disabled), the functions of the power supply module are all reset, and the resulting reset of fuel gauge data of the battery may lead to an error in measuring the remaining battery amount. Therefore, the ship mode technique may not regulate a charged amount correctly and cause problems such as an increase in a battery life and/or a charging time.

According to an embodiment of the disclosure, an electronic device for implementing a ship mode for minimizing power consumption in a battery pack independently of a system module, and a method of operating the electronic device may be provided.

### [Technical Solution]

The present invention is set out in the appended set of claims.

According to an embodiment of the disclosure, an electronic device includes a system module and a battery pack configured to be electrically connected to or disconnected from the system module. The battery pack includes a battery management module, a protective operation module, and a battery. The battery management module is configured to obtain battery state information by identifying a state of the battery, enable a ship mode for minimizing power consumed in the battery and control the protective operation module to electrically disconnect the system module and the battery pack from each other, based on the battery state information, and disable the ship mode and control the protective operation module to electrically connect the system module and the battery pack to each other, based on a power key included in the system module being connected to a first pin of the battery management module.

According to an embodiment of the disclosure, a method of operating an electronic device including a system module, and a battery pack configured to be electrically connected to or disconnected from the system module includes obtaining battery state information by identifying a state of a battery included in the battery pack by a battery management module included in the battery pack, enabling a ship mode for minimizing power consumed in the battery and electrically disconnecting the system module and the battery pack from each other, based on the battery state information, and disabling the ship mode and electrically connecting the system module and the battery pack to each other, based on a power key included in the system module being connected to a first pin of the battery management module.

According to an embodiment of the disclosure, a non-transitory storage medium stores executable instructions configured to, when executed by at least one processor, cause the at least one processor to perform at least one operation. The at least one operation includes obtaining battery state information by identifying a state of a battery included in a battery pack functionally connected to the processor by a battery management module included in the battery pack, enabling a ship mode for minimizing power consumed in the battery and electrically disconnecting a system module and the battery pack from each other, based on the battery state information, and disabling the ship mode and electrically connecting the system module and the battery pack to each other, based on a power key included in the system module being connected to a first pin.

### [Advantageous Effects]

According to an embodiment of the disclosure, a battery management module for identifying a battery state and performing a ship mode for minimizing current consumption is implemented in a battery pack independently of a system module in an electronic device. Therefore, the ship mode may be performed regardless of the electrical specifications of the system module, the current consumption of a battery may be reduced during execution of the ship mode, compared to the prior art, and an increase in the waiting time of the electronic device after the ship mode is released may be prevented.

Further, according to an embodiment of the disclosure, the electronic device may reduce the number of pins of the battery management module, which connect the battery management module and the system module, for the ship mode. Accordingly, the mounting structure of the battery pack may be improved.

Various other effects may be directly or indirectly identified from the disclosure.

### [Brief Description of Drawings]

FIG. 1 is a block diagram illustrating an electronic device in a network environment according to various embodiments.
FIG. 2 is a diagram illustrating an exemplary configuration of an electronic device according to an embodiment.
FIG. 3 is a diagram illustrating an exemplary configuration of an electronic device according to an embodiment.
FIG. 4 is a diagram illustrating an exemplary configuration of an electronic device according to an embodiment.
FIG. 5 is a diagram illustrating an exemplary configuration of an electronic device according to an embodiment.
FIG. 6 is a diagram illustrating an exemplary method of operation an electronic device according to an embodiment.

In connection with the description of the drawings, the same or similar reference numerals may be used for the same or similar components.

### [Mode for Carrying out the Invention]

An electronic device according to various embodiments will be described below with reference to the accompanying drawings. As used in various embodiments, the term user may refer to a person using an electronic device or a device (e.g., an artificial intelligence electronic device) using an electronic device.

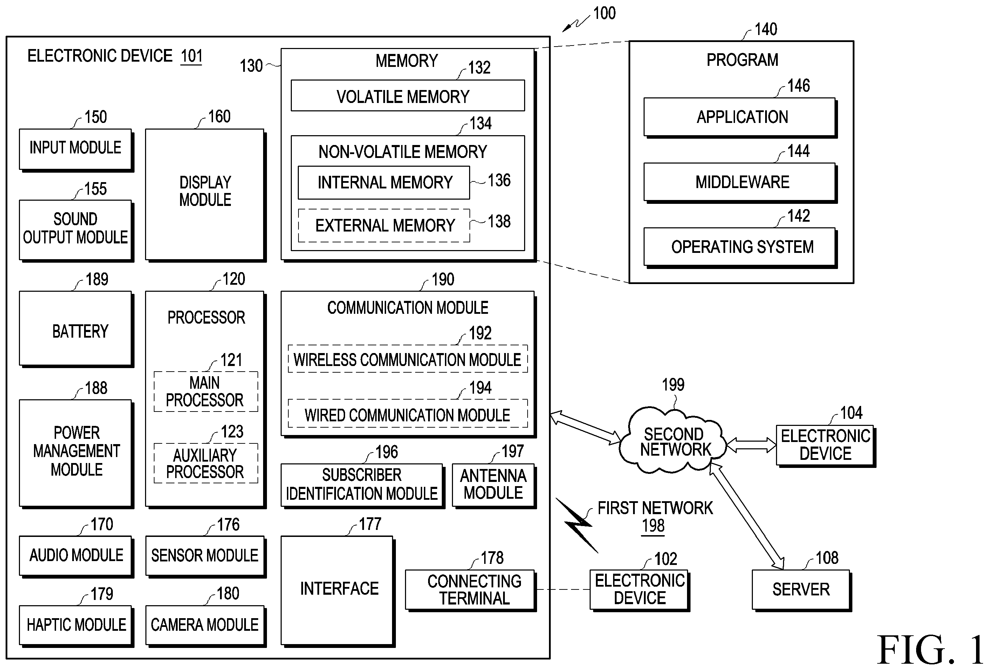

FIG. 1 is a block diagram illustrating an electronic device 101 in a network environment 100 according to various embodiments. Referring to FIG. 1, the electronic device 101 in the network environment 100 may communicate with an electronic device 102 through a first network 198 (e.g., a short-range wireless communication network), or at least one of an electronic device 104 or a server 108 through a second network 199 (e.g., a long-range wireless communication network). According to an embodiment, the electronic device 101 may communicate with the electronic device 104 through the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or through a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound through the input module 150, or output the sound through the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector through which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user through his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication through the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device through the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate . The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device through the selected at least one antenna. According to an embodiment, another component (e.g., a radio frequency integrated circuit (RFIC)) other than the radiating element may be additionally formed as part of the antenna module 197.

According to various embodiments, the antenna module 197 may form an mmWave antenna module. According to an embodiment, the mmWave antenna module may include a printed circuit board, a RFIC disposed on a first surface (e.g., the bottom surface) of the printed circuit board, or adjacent to the first surface and capable of supporting a specified high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the specified high-frequency band.

At least some of the above-described components may be coupled mutually and communicate signals (e.g., commands or data) therebetween through an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 through the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

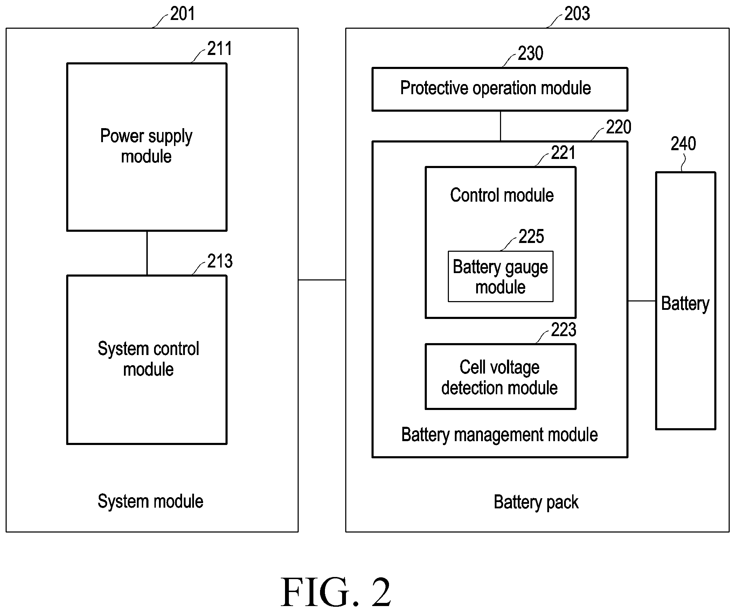

FIG. 2 is a diagram illustrating an exemplary configuration of an electronic device according to an embodiment.

Referring to FIGS. 1 and 2, the electronic device 101 according to an embodiment may be configured to include a system module 201 and a battery pack 203.

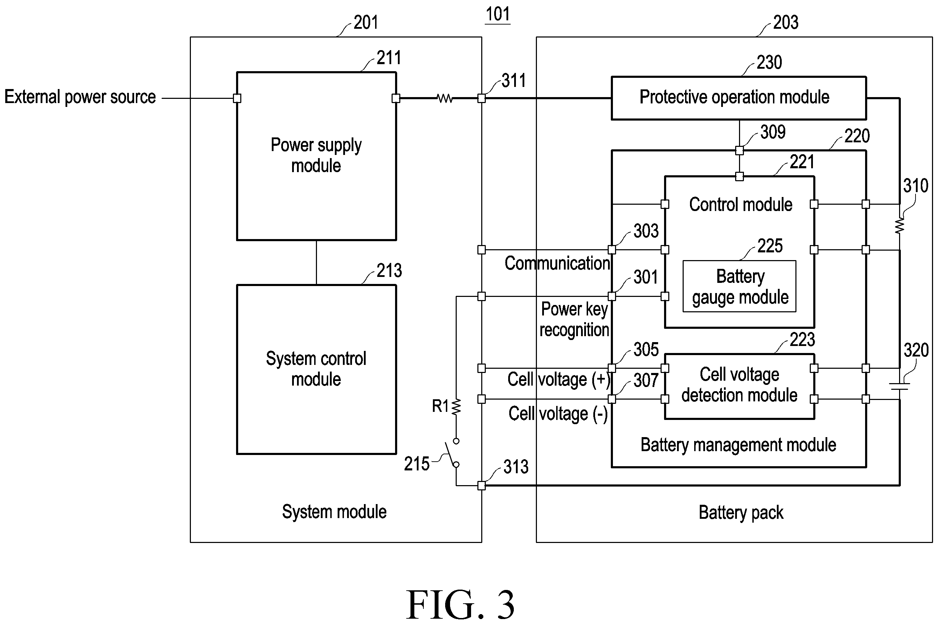

According to an embodiment, the system module 201 may be configured to be electrically connected to or disconnected from the battery pack 203 and to include a power supply module 211, a system control module 213, and a power key (e.g., a power key 215 of FIG. 3). The power supply module 211 may receive power required to operate the electronic device 101 from the battery pack 203 and supply the power to the system control module 213 and driving modules within the electronic device 101. For example, the power supply module 211 may control external power supplied from an external charging device (not shown), such as a travel adapter (TA), to be supplied to the battery pack 203 and charge a battery 240 included in the battery pack 203. The system control module 213 may be electrically connected to the power supply module 211, be operated by receiving power from the power supply module 211, and perform a control operation required to operate the electronic device 101.

According to an embodiment, the battery pack 203 may be configured to be electrically connected to or disconnected from the system module 201 and to include a battery management module 220, a protective operation module 230, and the battery 240.

According to an embodiment, the battery management module 220 may be configured to include a control module 221 electrically connected to the protective operation module 230 and the system module 201, and a cell voltage detection module 223 electrically connected to the system module 201 and/or the battery 240. For example, the battery management module 220 may be configured as a smart integrated circuit (IC) in the form of a chip. The battery management module 220 may include a plurality of pins for electrically connecting to the system module 201, the battery 240, and the protective operation module 230. The battery management module 220 may use some of the plurality of pins to enable or disable a ship mode. The battery management module 220 may identify whether it is necessary to disable the ship mode by connecting a specific pin (hereinafter, referred to as a first pin) to the power key 215 of the system module 201.

According to an embodiment, the battery management module 220 may control the control module 221 to continuously detect a battery state and record detected battery state information. For example, the battery state information may include information indicating a state (e.g., gauge, value, or level) of at least one of current, voltage, or temperature. The battery management module 220 may be configured to include a battery gauge module 225 within the control module 221 to continuously identify the battery state. For example, the battery gauge module 225 may be configured separately from the control module 221 in the battery management module 220, be electrically connected to the battery 240, continuously identify the state of the battery 240, and transmit obtained battery state information to the control module 221. For example, the battery gauge module 225 may be configured as a hardware or software module. The control module 221 may be connected to the protective operation module 230, control supply of power from the battery 240 to the power supply module 221 of the system module 201, and control the battery protective operation module 230 to perform a protective operation for the battery 240.

According to an embodiment, the battery management module 220 may detect a voltage applied to at least one battery cell included in the battery 240 by the cell voltage detection module 223.

According to an embodiment, the battery management module 220 may control the protective operation module 230 to electrically disconnect the system module 201 and the battery pack 203 from each other based on the battery state information obtained by the control module 221, and enable the ship mode to minimize the power consumption of the battery 240. When the battery state information satisfies a predetermined condition, the battery management module 220 may enable the ship mode. For example, the ship mode may be automatically enabled by the battery management module 220 without the control of the system module 201. For example, the predetermined condition may include a set condition that the state of the battery 240 is equal to or less than a specified threshold. The battery management module 220 may identify whether to enable the ship mode by comparing the battery state information with the specified threshold. When the battery state information is equal to or less than the specified threshold, the battery management module 220 may determine that the ship mode needs to be enabled and transmit a first control signal to the protective operation module 230 by the control module 211, for disconnection from the system module 201.

According to an embodiment, with the ship mode enabled, the battery management module 220 may identify whether the power key 215 is connected to the first pin based on a user input of the power key 215. For example, the battery management module 220 may identify an input signal input through the first pin (e.g., a power key recognition key) connected to the power key 215. The battery management module 220 may disable the ship mode and control the protective operation module 230 to electrically connect the system module 201 and the battery pack 203 to each other based on the input signal. For example, the ship mode may be disabled automatically by the battery management module 220 without the control of the system module 201. For example, the battery management module 220 may identify whether a voltage difference (or voltage drop) occurs due to a resistor in a path between the power key 215 and the first pin, through the first pin (e.g., a communication key or a positive cell voltage pin) connected to the power key 215. When a voltage difference occurs in the path between the power key 215 and the first pin, the battery management module 220 may disable the ship mode and control the protective operation module 230 to electrically connect the system module 201 and the battery pack 203 to each other based on the value of the voltage difference.

According to an embodiment, when disabling the ship mode based on the input signal, the battery management module 220 may transmit a second control signal to the protective operation module 230 to electrically connect the system module 201 and the battery pack 203 to each other.

According to an embodiment, the protective operation module 230 may be electrically connected to the battery management module 220 and the battery 240. The protective operation module 230 may be electrically connected to or disconnected from the power supply module 211 of the system module 201 under the control of the battery management module 220. For example, when receiving the first control signal from the battery management module 220, the protective operation module 230 may electrically disconnect the system module 201 and the battery pack 203 from each other to cut off power supplied from the battery 240 to the system module 201. For example, when receiving the second control signal from the battery management module 220, the protective operation module 230 may electrically connect the system module 201 and the **battery** pack 203 to each other to supply power from the battery 240 to the system module 201.

According to an embodiment, the battery 240 may include at least one battery cell and be electrically connected to the battery management module 220 and the protective operation module 230.

FIG. 3 is a diagram illustrating an exemplary configuration of an electronic device according to an embodiment.

Referring to FIGS. 2 and 3, according to an embodiment, the battery management module 220 of the battery pack 203 may use a power key recognition pin 301 as the first pin connected to the power key 215 to switch to an enabled or disabled state of the ship mode. The power key recognition pin 301 of the battery management module 220 may be connected to a + end of the power key 215. A resistor R1 may be connected between the power key 215 and the power key recognition pin 301. A - end of the power key 215 may be connected to a ground terminal GND 313 of the battery pack 203. The power key recognition pin 301 may be connected to the control module 221, and the control module 221 may be connected to both ends of a sensing resistor 310 connected to a + terminal of the battery 240. The control module 221 of the battery management module 220 may be connected to the system module 201 through a communication pin 303 and transmit battery state information and/or information related to the ship mode (e.g., information indicating the enabled or disabled state) to the system module 201 through the communication pin 303.

According to an embodiment, the cell voltage detection module 223 of the battery management module 220 may be connected to both ends (+ end and - end) of the at least one battery cell 320 included in the battery 240, and to a positive (+) cell voltage pin 305 and a negative (-) cell voltage pin 307 of the battery management module 220. The cell voltage detection module 223 may detect a voltage across both ends (+ end and - end) of the battery cell 320. The positive cell voltage pin 305 and the negative cell voltage pin 307 of the battery management module 220 may be connected to the system module 201. The battery management module 220 may connect the cell voltage detection module 223 to the system module 201 through the positive cell voltage pin 305 and the negative cell voltage pin 307. When the power key 215 is connected and thus the ship mode is disabled, the system module 201 may identify a voltage of the battery 240 using the positive cell voltage pin 305 and the negative cell voltage pin 307, and perform a battery charging or control operation using the identified voltage of the battery 240.

According to an embodiment, the protective operation module 230 of the battery pack 203 may be connected to the sensing resistor 310 connected to the battery cell 320 and a control pin 309 of the control module 221. The protective operation module 230 may be connected to a battery terminal BAT 311 connected to the power supply module 211 of the system module 201. The protective operation module 230 may electrically connect or electrically disconnect the system module 201 and the battery pack 203 through the battery terminal BAT 311 under the control of the control module 221.

According to an embodiment, the control module 221 of the battery management module 220 may continuously identify the state of the battery 240 using the sensing resistor 310. For example, the control module 221 may detect a resistance value of the sensing resistor 311 and obtain a current value of the battery 240 based on the detected resistance value. When the obtained current value is equal to or less than a specified current threshold (e.g., about 0mA) and a specified time elapses, the control module 221 may determine that the predetermined condition is satisfied. When the predetermined condition is satisfied, the control module 221 may identify that the ship mode needs to be enabled, and enable the ship mode to minimize the current consumption of the battery 240.

According to an embodiment, the control module 221 of the battery management module 220 may continuously identify a voltage and/or temperature of the battery 240. For example, the control module 221 may identify a voltage value across both ends (+ end and - end) of the battery cell 320 by the cell voltage detection module 223, and when the identified voltage value is equal to or less than a specified voltage value, determine that the predetermined condition is satisfied. When the predetermined condition is satisfied, the control module 221 may identify that the ship mode needs to be enabled and thus enable the ship mode. For example, the control module 221 may identify a temperature value based on heat of the battery 240 detected by at least one temperature sensor (not shown), and when the identified temperature value is equal to or greater than a specified temperature value, determine that the predetermined condition is satisfied. When the predetermined condition is satisfied, the control module 221 may identify that the ship mode needs to be enabled and thus enable the ship mode.

According to an embodiment, the control module 221 may continuously identify an ambient temperature of the battery cells 320 along with the voltage and/or current, and determine whether the predetermined condition is satisfied by compensating the voltage and/or current values of the battery 240 according to the temperature.

According to an embodiment, the control module 221 may transmit battery state information and/or information related to the ship mode (e.g., information indicating the enabled or disabled state) to the system module 201 through the communication pin 303. When the power key 215 is not pressed, the system module 201 may identify an off state of the power key 215. As the power key 215 is in the off state, the power key 215 may be disconnected from the power key recognition pin 301. When the system module 201 identifies that the battery 240 is in the enabled state of the ship mode, the system module 201 may be powered off and thus may not perform charging and operation control for the battery 240. The battery management module 220 may identify that the power key 215 is disconnected from the power key recognition pin 301, and transmit the first control signal to the protective operation module 230 by the control module 221 to electrically disconnect the system module 201 and the battery pack 203 from each other. When receiving the first control signal, the protective operation module 230 may disconnect the battery terminal BAT 311 connected to the power supply module 211 of the system module 201 to cut off power supplied from the battery 240.

According to an embodiment, the system module 201 may switch the power key 215 to an on state in response to a user input of the power key 215. As the power key 215 is switched to the on state, the power key 215 and the power key recognition pin 301 may be connected to each other. The control module 221 of the battery management module 220 may identify an input signal input through the power key recognition pin 301 connected to the power key 215, and identify that the power key 215 of the system module 201 has been switched to the on state, based on the identified input signal. The control module 221 of the battery management module 220 may disable the ship mode based on the identified input signal.

According to an embodiment, the control module 221 of the battery management module 220 may transmit the second control signal to the protective operation module 230, for electrical connection to the system module 201. When receiving the second control signal, the protective operation module 230 may connect to the battery terminal BAT 311 connected to the power supply module 211 of the system module 201 to supply power from the battery 240 to the system module 201. After the battery 240 and the power supply module 211 are connected through the protective operation module 230, the control module 221 may transmit battery state information and/or information indicating disabling of the ship mode as information related to the ship mode to the system module 201 through the communication pin 303.

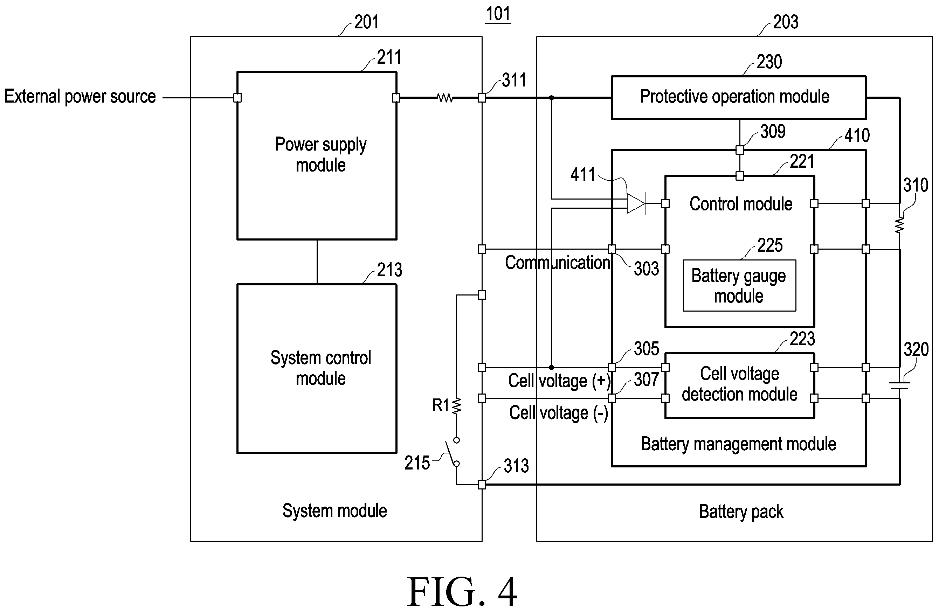

FIG. 4 is a diagram illustrating an exemplary configuration of an electronic device according to an embodiment.

Referring to FIGS. 2 and 4, according to an embodiment, a battery management module 410 (e.g., the battery management module 220 of FIG. 2) of the battery pack 203 may use the positive cell voltage pin 305 as the first pin connected to the power key 215 of the system module 201 to switch to the enabled or disabled state of the ship mode. The battery management module 220 according to another embodiment may not include the power key recognition pin 301 of the battery management module 220 according to the embodiment described above with reference to FIG. 3. The positive cell voltage pin 305 of the battery management module 410 may be connected to the + end of the power key 215. The resistor R1 may be connected between the power key 215 and the positive cell voltage pin 305. The - end of the power key 215 may be connected to the ground terminal GND 313 of the battery pack 203. The control module 221 may be connected to both ends (+ end and - end) of the sensing resistor 310 connected to the + terminal of the battery 240. The control module 221 of the battery management module 410 may be connected to the system module 201 through the communication pin 303 and transmit battery state information and/or information related to the ship mode (e.g., information indicating the enabled or disabled state) to the system module 201 through the communication pin 303.

According to an embodiment, the cell voltage detection module 223 of the battery management module 410 may be connected to both ends (+ end and - end) of the at least one battery cell 320 included in the battery 240, and to the positive cell voltage pin 305 and the negative cell voltage pin 307 of the battery management module 410. The cell voltage detection module 223 may detect a voltage across both ends (+ end and - end) of the battery cell 320. The positive cell voltage pin 305 and the negative cell voltage pin 307 of the battery management module 410 may be connected to the system module 201. The battery management module 410 may connect the cell voltage detection module 223 to the system module 201 through the positive cell voltage pin 305 and the negative cell voltage pin 307. When the power key 215 is connected and thus the ship mode is disabled, the system module 201 may identify the voltage of the battery 240 using the positive cell voltage pin 305 and the negative cell voltage pin 307, and perform a battery charging or control operation using the identified voltage of the battery 240.

According to an embodiment, the protective operation module 410 of the battery pack 203 may be connected to the sensing resistor 310 connected to the battery cell 320 and the control pin 309 of the control module 221. The protective operation module 230 may be connected to the battery terminal BAT 311 connected to the power supply module 211 of the system module 201. The protective operation module 230 may be connected to or disconnected from the battery terminal 311 under the control of the control module 221.

According to an embodiment, the battery management module 410 may include an element 411 for measuring a voltage difference (e.g., a comparator) connected between the positive cell voltage pin 305 and the battery terminal BAT 311. The control module 221 of the battery management module 410 may detect a voltage difference between the positive cell voltage pin 305 and the battery terminal BAT 311, using the element 411 for measuring a voltage difference. The battery management module 410 may identify that the power key 215 is disconnected from the positive cell voltage pin 305, based on the detected voltage difference (e.g., voltage step-up), and enable the ship mode. When the ship mode is enabled, the system module 201 may be in a powered-off state with the power key 215 turned off and not perform charging and operation control through the positive cell voltage pin 305. Since the positive cell voltage pin 305 does not affect the system module 201, the battery management module 410 may identify whether the ship mode is disabled, using the positive cell voltage pin 305.

According to an embodiment, the control module 221 of the battery management module 410 may continuously identify the state of the battery 240, using the sensing resistor 310. For example, the control module 221 may detect a resistance value of the sensing resistor 310 and obtain a current value of the battery 240 based on the detected resistance value. When the obtained current value is equal to or less than a specified current threshold and a specified time elapses, the control module 221 may determine that the predetermined condition is satisfied. When the predetermined condition is satisfied, the control module 221 may identify that the ship mode needs to be enabled and enable the ship mode to minimize the current consumption of the battery 240. The control module 221 may transmit battery state information and/or information related to the ship mode (e.g., information indicating the enabled or disabled state) to the system module 201 through the communication pin 303. When receiving information indicating the enabled state of the ship mode as the information related to the ship mode, the system module 201 may switch the power key 215 to the off state. The system module 201 may identify the state of the battery 240 using the battery state information and use the identified state for battery charging control and operation control. The battery management module 410 may transmit the first control signal to the protective operation module 230 to electrically disconnect the system module 201 and the battery pack 203 from each other. When receiving the first control signal, the protective operation module 230 may disconnect the battery terminal BAT 311 connected to the power supply module 211 of the system module 201 to cut off power supply from the battery 240.

According to an embodiment, the battery management module 410 may set a threshold (or threshold value) to be used for enabling the ship mode, based on a specified value kΩ of the resistor R1 connected to the power key 215 and a voltage difference (or voltage step-up) value mV generated by the specified resistance value. The battery management module 410 may detect the voltage difference generated at the positive cell voltage pin 305, caused by the resistor R1 connected to the power key 215. When the detected voltage difference value is equal to or less than the set threshold in the enabled state of the ship mode, the battery management module 410 may determine that as the power key 215 is switched to the on state, the ship mode needs to be disabled, and thus disable the ship mode. For example, in the disabled state of the ship mode, the positive cell voltage pin 305 and the battery terminal 311 may have substantially the same potential. The control module 221 of the battery management module 410 may transmit the second control signal to the protective operation module 230, for electrical connection to the system module 201. When receiving the second control signal, the protective operation module 230 may be connected to the battery terminal BAT 311 connected to the power supply module 211 of the system module 201 to supply power from the battery 240 to the system module 201.

According to an embodiment, when the ship mode is identified as requiring disabling, or when the ship mode is disabled, the battery management module 410 may transmit battery state information and/or information indicating disabling of the ship mode as information related to the ship mode to the system module 201 through the communication pin 303 by the control module 221. The system module 201 may identify the state of the battery 240 using the battery state information and use the identified state for battery charging control or operation control.

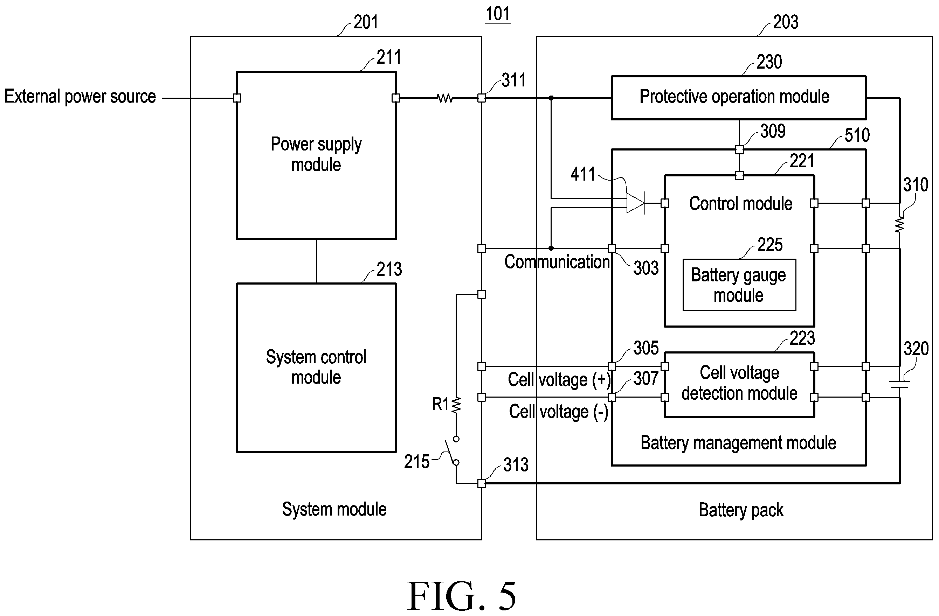

FIG. 5 is a diagram illustrating an exemplary configuration of an electronic device according to an embodiment.

Referring to FIGS. 2 and 5, according to an embodiment, a battery management module 510 (e.g., the battery management module 220 of FIG. 2) of the battery pack 203 may use the communication pin 303 as the first pin connected to the power key 215 to switch to the enabled or disabled state of the ship mode. When an input of the power key 215 occurs in the enabled state of the ship mode, the battery management module 510 may detect a voltage difference across the communication pin 303 by the resistor R1 connected to the power key 215, compare the detected voltage difference value with a set threshold value, determine that the ship mode needs to be disabled when the detected voltage difference value is equal to or less than the threshold value, and disable the ship mode.

The battery management module 220 according to an embodiment may not include the power key recognition pin 301 of the battery management module 220 according to the embodiment described above with reference to FIG. 3.

The battery management module 510 according to an embodiment described with reference to FIG. 5 may be implemented and operate identically to the battery management module 410 described above with reference to FIG. 4, except that the first pin connected to the power key 215 is the communication pin 303.

The main components of an electronic device have been described with reference to the electronic device 101 of FIGS. 1 and 2 in the above embodiment. However, all of the components illustrated in FIGS. 1 and 2 are not required components, and the electronic device 101 may be implemented with more or fewer components than those illustrated. Further, the positions of the main components of the electronic device 101 described with reference to FIGS. 1 and 2 may be changed according to an embodiment.

According to an embodiment, an electronic device (e.g., the electronic device 101 of FIGS. 1 and 2) may include a system module (e.g., the system module 201 of FIGS. 2, 3, 4 and 5) and a battery pack (e.g., the battery pack 203 of FIGS. 2, 3, 4 and 5) configured to be electrically connected to or disconnected from the system module. The battery pack may include a battery management module (e.g., the battery management module 220 of FIGS. 2 and 3, the battery management module 410 of FIG. 4, and the battery management module 510 of FIG. 5), a protective operation module (e.g., the protective operation module 230 of FIGS. 2, 3, 4 and 5), and a battery (e.g., the battery 240 of FIGS. 2, 3, 4 and 5). The battery management module may be configured to obtain battery state information by identifying a state of the battery, enable a ship mode for minimizing power consumed in the battery and control the protective operation module to electrically disconnect the system module and the battery pack from each other, based on the battery state information, and disable the ship mode and control the protective operation module to electrically connect the system module and the battery pack to each other, based on a power key included in the system module being connected to a first pin of the battery management module.

The battery management module includes a cell voltage detection module (e.g., the cell voltage detection module 223 of FIGS. 2, 3, 4, and 5) configured to detect a cell voltage of the battery, and a control module (e.g., the control module 221 of FIGS. 2, 3, 4, and 5) continuously configured to identify the state of the battery and control enabling or disabling of the ship mode.

According to an embodiment, the battery management module may be configured to, when the battery state information satisfies a predetermined condition, enable the ship mode and transmit a first control signal to the protective operation module to electrically disconnect the system module and the battery pack from each other. The first pin may be a power key recognition pin, a communication pin, or a positive cell voltage pin, and may not be connected to the power key, when the ship mode is enabled.

According to an embodiment, when receiving the first control signal from the battery management module, the protective operation module may configured to disconnect the system module from the power supply module.

According to an embodiment, the predetermined condition may include a set condition that the state of the battery is equal to or less than a specified threshold, and the battery state information may include information indicating a state of at least one of current, voltage, or temperature.

According to an embodiment, the battery management module may be configured to, when the ship mode is disabled based on the input signal, transmit a second control signal to the protective operation module to electrically connect the system module and the battery pack to each other.

According to an embodiment, when receiving the second control signal from the battery management module, the protective operation module may configured to be electrically connected to a power supply module of the system module to supply power from the battery to the system module.

According to embodiment, the battery management module may be configured to, when the power key is connected to a power key recognition pin as the first pin in an enabled state of the ship mode, identify an input signal input through the power key recognition pin, and disable the ship mode based on the identified input signal.

According to an embodiment, wherein the battery management module may be configured to, when the power key is connected to a communication pin as the first pin in an enabled state of the ship mode, obtain a voltage difference value in a connection path between the power key and the communication pin, and when the voltage difference value is equal to or less than a specified threshold, disable the ship mode.

According to an embodiment, the battery management module may be configured to, when the power key is connected to a positive cell voltage pin as the first pin in an enabled state of the ship mode, obtain a voltage difference value in a connection path between the power key and the positive cell voltage pin, and when the voltage difference value is equal to or less than a specified threshold, disable the ship mode.

A method of operating an electronic device according to an embodiment will be described below.

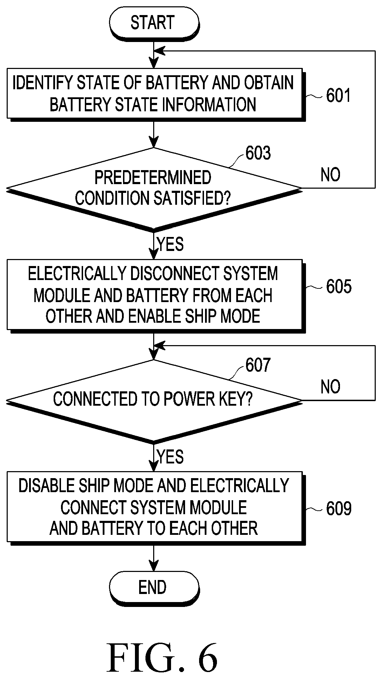

FIG. 6 is a diagram illustrating an exemplary method of operating an electronic device according to an embodiment.

Referring to FIG. 6, a method of operating an electronic device (e.g., the electronic device 101 of FIGS. 1 and 2) according to an embodiment may be performed by a battery management module (e.g., the battery management module 220 of FIGS. 2 and 3, the battery management module 410 of FIG. 4, or the battery management module 510 of FIG. 5) included in a battery pack (e.g., the battery pack 203 of FIGS. 2, 3, 4, and 5) configured to be electrically connected to or disconnected from a system module (e.g., the system module 201 of FIGS. 2, 3, 4, and 5).

In operation 601, the battery management module may obtain battery state information by identifying the state of a battery (e.g., the battery 240 of FIGS. 2, 3, 4, and 5). The battery management module may continuously identify the state of the battery using a sensing resistor (e.g., the sensing resistor 310 of FIGS. 3, 4, and 5) connected to at least one battery cell included in the battery. For example, the control module 221 may detect a resistance value of the sensing resistor 311 and obtain the detected resistance value as battery state information.

In operation 603, the battery management module may identify whether a predetermined condition is satisfied based on the battery state information. For example, the predetermined condition may include a set condition that the state of the battery is equal to or less than a specified threshold, and the battery state information may include information indicating the state of at least one of current, voltage, or temperature. For example, the battery management module may obtain a current value of the battery 240 based on the detected resistance value. When the obtained current value is equal to or less than a specified current threshold, and a specified time elapses, the control module 221 may determine that the predetermined condition is satisfied, which requires enabling of the ship mode.

When the battery state information satisfies the predetermined condition as a result of the identification in operation 603, the battery management module may perform operation 605. Otherwise, the battery management module may perform operation 601 again.

In operation 605, the battery management module may identify that the ship mode needs to be enabled, and enable the ship mode to minimize the power consumption of the battery. The battery management module may control a protective operation module (e.g., the protective operation module 230 of FIGS. 2, 3, 4, and 5) included in the battery pack to electrically disconnect the system module and the battery pack from each other. When the ship mode is enabled, the battery management module may transmit a first control signal through a control pin (e.g., the control pin 309 in FIGS. 3, 4, and 5) connected to the protective operation module to electrically disconnect the system module and the battery pack from each other. When receiving the first control signal from the battery management module, the protective operation module may disconnect the power supply module of the system module. For example, when the ship mode is enabled by the battery management module, the current consumption may be reduced, for example, from about 10uA to about 0.5uA in the enabled state of the ship mode. In operation 607, the battery management module may identify whether a power key is connected to a first pin based on an input of a power key included in the system module in the enabled state of the ship mode. When the battery management module identifies that the power key is connected to the first pin as a result of the identification, the battery management module may perform operation 609, and otherwise, perform operation 607 again. For example, the first pin may be a power recognition pin (e.g., the power recognition key 301 of FIG. 3) of the battery management module. In another example, the first pin may be a communication pin (e.g., the communication pin 303 of FIGS. 3, 4, and 5). In another example, the first pin may be a positive cell voltage pin (e.g., the positive cell voltage pin 305 of FIGS. 3, 4, and 5).

In operation 609, the battery management module may disable the ship mode and control the protective operation module to electrically connect the system module and the battery pack to each other. When the ship mode is disabled, the battery management module may transmit a second control signal through the control pin connected to the protective operation module to electrically connect the system module and the battery pack to each other. When receiving the second control signal from the battery management module, the protective operation module may electrically connect to a power supply module of the system module to supply power from the battery to the system module.

In operation 605 of the operation method described above with reference to FIG. 6, when the ship mode is enabled, or when it is identified that the ship mode needs to be enabled, the battery management module may transmit battery state information and/or information related to the ship mode to the system module 201 through the communication pin 303. When receiving information indicating enabling of the ship mode as the information related to the ship mode, the system module 201 may switch the power key 215 to the off state. As the power key is switched to the off state, the power key and the power key recognition pin (e.g., the power key recognition pin 301 of FIG. 3) may be disconnected from each other. For example, as the power key 215 is disconnected, the battery management module may identify that the power key has been switched to the off state because an input signal input through the power key recognition pin connected to the power key is not identified. In another example, the battery management module may identify that the power key has been switched to the off state by identifying that there is no potential difference between the communication pin connected to the power key or the positive cell voltage pin and the battery terminal BAT.

When performing operation 605 of FIG. 6, the system module 201 may identify the state of the battery 240 using the battery state information received from the battery management module through the communication pin, and use the identified state for battery charge control and operation control. For example, the system module may display the state of the battery on a display module (e.g., the display module 160 of FIG. 1) using the battery state information. For example, the system module 201 may display the information related to the ship mode on the display module (e.g., the display module 160 of FIG. 1).

In operation 609 of the operation method described above with reference to FIG. 6, when the ship mode is disabled, or when it is identified that the ship mode needs to be disabled, the battery management module may transmit the battery state information and/or information related to disabling of the ship mode to the system module 201 through the communication pin 303. The system module may display the received battery state information and/or information indicating disabling of the ship mode on the display module (e.g., the display module 160 of FIG. 1).

In the operation method described above with reference to FIG. 6, according to various embodiments, the power key may be connected to the power key recognition pin (e.g., the communication pin 301 of FIG. 3), the communication pin (e.g., the communication pin 303 of FIGS. 3, 4, and 5), or the positive cell voltage pin (e.g., the positive cell voltage pin 305 of FIGS. 3, 4, and 5) as the first pin, in response to input of the power key included in the system module in the enabled state of the ship mode.

In operation 605 of FIG. 6 above, according to an embodiment, when the power key is connected to the power key recognition pin, the battery management module may identify an input signal input through the power key recognition pin and disable the ship mode, based on the identified input signal.

In operation 605 of FIG. 6, according to another embodiment, when the power key is connected to the communication pin or the positive cell voltage pin, the battery management module may detect a voltage difference of the communication pin, caused by a resistor (e.g., the resistor R1 of FIGS. 3, 4, and 5) connected to the power key, compare the detected voltage difference value with a set threshold, determine that the ship mode needs to be disabled, when the detected voltage difference is equal to or less than the threshold, and disable the ship mode. For example, when the power key is connected to the communication pin or the positive cell voltage pin, the battery management module may be configured without including the power key recognition pin. The resulting decrease in the number of pins in the battery management module may simplify a mounting structure of the battery management module.

According to an embodiment, a method of operating an electronic device (e.g., the electronic device 101 of FIGS. 1 and 2) including a system module (e.g., the system module 201 of FIGS. 2, 3, 4, and 5), and a battery pack (e.g., the battery 203 of FIGS. 2, 3, 4, and 5) configured to be electrically connected to or disconnected from the system module may include obtaining battery state information by identifying a state of a battery included in the battery pack by a battery management module (e.g., the battery management module 220 of FIGS. 2 and 3, the battery management module 410 of FIG. 4, and the battery management module 510 of FIG. 5) included in the battery pack, enabling a ship mode for minimizing power consumed in the battery and electrically disconnecting the system module and the battery pack from each other, based on the battery state information, and disabling the ship mode and electrically connecting the system module and the battery pack to each other, based on a power key included in the system module being connected to a first pin of the battery management module.

According to an embodiment, the method may further include identifying whether the battery state information satisfies a predetermined condition, and transmitting the battery state information or information related to the ship mode to the system module.

According to an embodiment, enabling the ship mode and electrically disconnecting the system module and the battery pack from each other may include, when the battery state information satisfies the predetermined condition, enabling the ship mode, and when the battery state information satisfies the predetermined condition, transmitting a first control signal to a protective operation module of the battery pack to electrically disconnect the system module and the battery pack from each other.

According to an embodiment, the first pin may be a power key recognition pin, a communication pin, or a positive cell voltage pin, and may not be connected to the power key, when the ship mode is enabled,

According to an embodiment, the predetermined condition may include a set condition that the state of the battery is equal to or less than a specified threshold, and the battery state information may include information indicating a state of at least one of current, voltage, or temperature.

According to an embodiment, electrically connecting the system module and the battery pack to each other may include transmitting a second control signal to the protective operation module to electrically connect the system module and the battery pack to each other.

According to an embodiment, disabling the ship mode may include, when the power key is connected to a power key recognition pin as the first pin in an enabled state of the ship mode, identifying an input signal input through the power key recognition pin, and disabling the ship mode based on the identified input signal.

According to an embodiment, disabling the ship mode may include, when the power key is connected to a communication pin as the first pin in an enabled state of the ship mode, obtaining a voltage difference value in a connection path between the power key and the communication pin, and when the voltage difference value is equal to or less than a specified threshold, disabling the ship mode.

According to an embodiment, disabling the ship mode may include, when the power key is connected to a positive cell voltage pin as the first pin in an enabled state of the ship mode, obtaining a voltage difference value in a connection path between the power key and the positive cell voltage pin, and when the voltage difference value is equal to or less than a specified threshold, disabling the ship mode.

According to an embodiment, in a non-transitory storage medium storing executable instructions configured to, when executed by at least one processor of an electronic device, cause the electronic device to perform at least one operation, the at least one operation may include obtaining battery state information by identifying a state of a battery included in a battery pack functionally connected to the processor by a battery management module included in the battery pack, enabling a ship mode for minimizing power consumed in the battery and electrically disconnecting a system module and the battery pack from each other, based on the battery state information, and disabling the ship mode and electrically connecting the system module and the battery pack to each other, based on a power key included in the system module being connected to a first pin.

The embodiments disclosed herein are presented for the description and understanding of the technical ideas, not intended to limit the technical scope of the disclosure.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1^{st}" and "2^{nd}", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or through a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online through an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a system module (201); and
a battery pack (203) configured to be electrically connected to or disconnected from the system module (201),
wherein the battery pack (203) includes a battery management module (220), a protective operation module (230), and a battery (240), and
wherein the battery management module (220) is configured to:
obtain battery state information by identifying a state of the battery (240),
enable a ship mode for minimizing power consumed in the battery (240) and control the protective operation module (230) to electrically disconnect the system module (201) and the battery pack (203) from each other, based on the battery state information, and
disable the ship mode and control the protective operation module (230) to electrically connect the system module (201) and the battery pack (203) to each other, based on a power key (215) included in the system module (201) being connected through a resistor (R1) to a first pin of the battery management module (220),
wherein the battery management module (220) includes a cell voltage detection module (223) configured to detect a cell voltage of the battery (240) and connected to the system module (201) through a positive cell voltage pin (305) and a negative cell voltage pin (307) of the battery management module (220),
wherein the first pin includes the positive cell voltage pin (305).

2. The electronic device (101) of claim 1, wherein the battery management module (220) includes:
a control module continuously configured to identify the state of the battery (240) and controlling enabling or disabling of the ship mode.

3. The electronic device (101) of claim 1, wherein the battery management module (220) is further configured to, when the battery state information satisfies a predetermined condition, enable the ship mode and transmit a first control signal to the protective operation module (230) to electrically disconnect the system module (201) and the battery pack (203) from each other,
wherein the first pin further includes a power key recognition pin (301), or a communication pin (303), and is not connected to the power key (215), when the ship mode is enabled,
wherein when receiving the first control signal from the battery management module (220), the protective operation module (230) is configured to disconnect the system module (201) from a power supply module,
wherein the predetermined condition includes a set condition that the state of the battery (240) is equal to or less than a specified threshold, and
wherein the battery state information includes information indicating a state of at least one of current, voltage, or temperature.

4. The electronic device (101) of claim 1, wherein the battery management module (220) is further configured to, when the ship mode is disabled based on an input signal, transmit a second control signal to the protective operation module (230) to electrically connect the system module (201) and the battery pack (203) to each other, and
wherein when receiving the second control signal from the battery management module (220), the protective operation module (230) is configured to be electrically connected to a power supply module of the system module (201) to supply power from the battery (240) to the system module (201).

5. The electronic device (101) of claim 1, wherein the battery management module (220) is further configured to:
when the power key (215) is connected to a power key recognition pin (301) as the first pin in an enabled state of the ship mode, identify an input signal input through the power key recognition pin (301), and
disable the ship mode based on the identified input signal.

6. The electronic device (101) of claim 1, wherein the battery management module (220) is further configured to:
when the power key (215) is connected to a communication pin (303) as the first pin in an enabled state of the ship mode, obtain a voltage difference value in a connection path between the power key (215) and the communication pin (303), and
when the voltage difference value is equal to or less than a specified threshold, disable the ship mode.

7. The electronic device (101) of claim 1, wherein the battery management module (220) is further configured to:
when the power key (215) is connected to the positive cell voltage pin (305) as the first pin in an enabled state of the ship mode, obtain a voltage difference value in a connection path between the power key (215) and the positive cell voltage pin (305), and
when the voltage difference value is equal to or less than a specified threshold, disable the ship mode.

8. A method of operating an electronic device (101) including a system module (201), and a battery pack (203) configured to be electrically connected to or disconnected from the system module (201), the method comprising:
obtaining battery state information by identifying a state of a battery included in the battery pack by a battery management module (220) included in the battery pack (203);
enabling a ship mode for minimizing power consumed in a battery (240) and electrically disconnecting the system module (201) and the battery pack (203) from each other, based on the battery state information; and
disabling the ship mode and electrically connecting the system module (201) and the battery pack (203) to each other, based on a power key (215) included in the system module (201) being connected through a resistor (R1) to a first pin of the battery management module (220),
wherein the battery management module (220) includes a cell voltage detection module (223) configured to detect a cell voltage of the battery (240) and connected to the system module (201) through a positive cell voltage pin (305) and a negative cell voltage pin (307) of the battery management module (220),
wherein the first pin includes the positive cell voltage pin (305).

9. The method of claim 8, further comprising:
identifying whether the battery state information satisfies a predetermined condition; and
transmitting the battery state information or information related to the ship mode to the system module (201).

10. The method of claim 9, wherein enabling the ship mode and electrically disconnecting the system module (201) and the battery pack (203) from each other comprises:
when the battery state information satisfies the predetermined condition, enabling the ship mode; and
when the battery state information satisfies the predetermined condition, transmitting a first control signal to a protective operation module (230) of the battery pack (203) to electrically disconnect the system module (201) and the battery pack (203) from each other, wherein the first pin further includes a power key recognition pin (301), or a communication pin (303), and is not connected to the power key (215), when the ship mode is enabled,
wherein the predetermined condition includes a set condition that the state of the battery (240) is equal to or less than a specified threshold, and
wherein the battery state information includes information indicating a state of at least one of current, voltage, or temperature.

11. The method of claim 8, wherein electrically connecting the system module (201) and the battery pack (203) to each other comprises transmitting a second control signal to a protective operation module (230) to electrically connect the system module (201) and the battery pack (203) to each other.

12. The method of claim 8, wherein disabling the ship mode comprises:
when the power key (215) is connected to a power key recognition pin (301) as the first pin in an enabled state of the ship mode, identifying an input signal input through the power key recognition pin (301); and
disabling the ship mode based on the identified input signal.

13. The method of claim 8, wherein disabling the ship mode comprises:
when the power key (215) is connected to a communication pin (303) as the first pin in an enabled state of the ship mode, obtaining a voltage difference value in a connection path between the power key (215) and the communication pin (303); and
when the voltage difference value is equal to or less than a specified threshold, disabling the ship mode.

14. The method of claim 8, wherein disabling the ship mode comprises:
when the power key (215) is connected to the positive cell voltage pin (305) as the first pin in an enabled state of the ship mode, obtaining a voltage difference value in a connection path between the power key (215) and the positive cell voltage pin (305); and
when the voltage difference value is equal to or less than a specified threshold, disabling the ship mode.

15. A non-transitory storage medium storing executable instructions configured to, when executed by at least one processor of an electronic device (101), cause the electronic device (101) to perform at least one operation,
wherein the at least one operation includes:
obtaining battery state information by identifying a state of a battery included in a battery pack (203) functionally connected to the processor by a battery management module (220) included in the battery pack (203);
enabling a ship mode for minimizing power consumed in a battery (240) and electrically disconnecting a system module (201) and the battery pack (203) from each other, based on the battery state information; and
disabling the ship mode and electrically connecting the system module (201) and the battery pack (203) to each other, based on a power key (215) included in the system module (201) being connected through a resistor (R1) to a first pin of the battery management module (220),
wherein the battery management module (220) includes a cell voltage detection module (223) configured to detect a cell voltage of the battery (240) and connected to the system module (201) through a positive cell voltage pin (305) and a negative cell voltage pin (307) of the battery management module (220),
wherein the first pin includes the positive cell voltage pin (305).

## Patentansprüche

1. Elektronische Vorrichtung (101), umfassend:
ein Systemmodul (201); und
einen Batteriepack (203), der so konfiguriert ist, dass er elektrisch mit dem Systemmodul (201) verbunden oder von diesem getrennt werden kann,
wobei der Batteriepack (203) ein Batteriemanagementmodul (220), ein Schutzbetriebsmodul (230) und eine Batterie (240) umfasst, und
wobei das Batteriemanagementmodul (220) dazu konfiguriert ist:
Batteriezustandsinformationen durch Identifizieren eines Zustands der Batterie (240) zu erhalten,
einen Schiffsmodus zur Minimierung des in der Batterie (240) verbrauchten Stroms zu aktivieren und das Schutzbetriebsmodul (230) zu steuern, um das Systemmodul (201) und den Batteriepack (203) auf der Grundlage der Batteriezustandsinformationen elektrisch voneinander zu trennen, und
den Schiffsmodus zu deaktivieren und das Schutzbetriebsmodul (230) zu steuern, um das Systemmodul (201) und den Batteriepack (203) basierend darauf, dass eine im Systemmodul (201) enthaltene Ein-/Aus-Taste (215) über einen Widerstand (R1) mit einem ersten Pin des Batteriemanagementmoduls (220) verbunden ist, elektrisch miteinander zu verbinden,
wobei das Batteriemanagementmodul (220) ein Zellspannungserfassungsmodul (223) umfasst, das dazu konfiguriert ist, eine Zellspannung der Batterie (240) zu erfassen, und über einen positiven Zellspannungs-Pin (305) und einen negativen Zellspannungs-Pin (307) des Batteriemanagementmoduls (220) mit dem Systemmodul (201) verbunden ist,
wobei der erste Pin den positiven Zellspannungs-Pin (305) umfasst.

2. Elektronische Vorrichtung (101) nach Anspruch 1, wobei das Batteriemanagementmodul (220) Folgendes umfasst:
ein Steuermodul, das kontinuierlich dazu konfiguriert ist, den Zustand der Batterie (240) zu identifizieren, und die Aktivierung oder Deaktivierung des Schiffsmodus steuert.

3. Elektronische Vorrichtung (101) nach Anspruch 1, wobei das Batteriemanagementmodul (220) ferner dazu konfiguriert ist, wenn die Batteriezustandsinformationen eine vorbestimmte Bedingung erfüllen, den Schiffsmodus zu aktivieren und ein erstes Steuersignal an das Schutzbetriebsmodul (230) zu übertragen, um das Systemmodul (201) und den Batteriepack (203) elektrisch voneinander zu trennen,
wobei der erste Pin ferner einen Ein-/Aus-Taste-Erkennungspin (301) oder einen Kommunikations-Pin (303) umfasst und nicht mit der Ein-/Aus-Taste (215) verbunden ist, wenn der Schiffsmodus aktiviert ist,
wobei beim Empfang des ersten Steuersignals vom Batteriemanagementmodul (220) das Schutzbetriebsmodul (230) dazu konfiguriert ist, das Systemmodul (201) von einem Stromversorgungsmodul zu trennen,
wobei die vorbestimmte Bedingung eine eingestellte Bedingung umfasst, dass der Zustand der Batterie (240) gleich oder kleiner als ein festgelegter Schwellenwert ist, und
wobei die Batteriezustandsinformationen Informationen umfassen, die einen Zustand mindestens eines von Folgendem angeben: Strom, Spannung und Temperatur.

4. Elektronische Vorrichtung (101) nach Anspruch 1, wobei das Batteriemanagementmodul (220) ferner dazu konfiguriert ist, wenn der Schiffsmodus auf der Grundlage eines Eingangssignals deaktiviert wird, ein zweites Steuersignal an das Schutzbetriebsmodul (230) zu übertragen, um das Systemmodul (201) und den Batteriepack (203) elektrisch miteinander zu verbinden, und
wobei das Schutzbetriebsmodul (230) beim Empfang des zweiten Steuersignals vom Batteriemanagementmodul (220) so konfiguriert ist, dass es elektrisch mit einem Stromversorgungsmodul des Systemmoduls (201) verbunden wird, um das Systemmodul (201) mit Strom aus der Batterie (240) zu versorgen.

5. Elektronische Vorrichtung (101) nach Anspruch 1, wobei das Batteriemanagementmodul (220) ferner dazu konfiguriert ist:
wenn die Ein-/Aus-Taste (215) in einem aktivierten Zustand des Schiffsmodus mit einem Ein-/Aus-Taste-Erkennungspin (301) als dem ersten Pin verbunden ist, ein über den Ein-/Aus-Taste-Erkennungspin (301) eingegebenes Eingangssignal zu identifizieren und
den Schiffsmodus auf der Grundlage des identifizierten Eingangssignals zu deaktivieren.

6. Elektronische Vorrichtung (101) nach Anspruch 1, wobei das Batteriemanagementmodul (220) ferner dazu konfiguriert ist:
wenn die Ein-/Aus-Taste (215) in einem aktivierten Zustand des Schiffsmodus mit einem Kommunikations-Pin (303) als dem ersten Pin verbunden ist, einen Spannungsdifferenzwert in einem Verbindungspfad zwischen der Ein-/Aus-Taste (215) und dem Kommunikations-Pin (303) zu erhalten, und
wenn der Spannungsdifferenzwert gleich oder kleiner als ein festgelegter Schwellenwert ist, den Schiffsmodus zu deaktivieren.

7. Elektronische Vorrichtung (101) nach Anspruch 1, wobei das Batteriemanagementmodul (220) ferner dazu konfiguriert ist:
wenn die Ein-/Aus-Taste (215) in einem aktivierten Zustand des Schiffsmodus mit dem positiven Zellspannungs-Pin (305) als dem ersten Pin verbunden ist, einen Spannungsdifferenzwert in einem Verbindungspfad zwischen der Ein-/Aus-Taste (215) und dem positiven Zellspannungs-Pin (305) zu erhalten, und
wenn der Spannungsdifferenzwert gleich oder kleiner als ein festgelegter Schwellenwert ist, den Schiffsmodus zu deaktivieren.

8. Verfahren zum Betreiben einer elektronischen Vorrichtung (101), die ein Systemmodul (201) und einen Batteriepack (203) umfasst, der so konfiguriert ist, dass er elektrisch mit dem Systemmodul (201) verbunden oder von diesem getrennt werden kann, wobei das Verfahren Folgendes umfasst:
Erhalten von Batteriezustandsinformationen durch Identifizieren eines Zustands einer im Batteriepack enthaltenen Batterie über ein im Batteriepack (203) enthaltenes Batteriemanagementmodul (220);
Aktivieren eines Schiffsmodus zur Minimierung des in einer Batterie (240) verbrauchten Stroms und elektrisches Trennen des Systemmoduls (201) und des Batteriepacks (203) voneinander auf der Grundlage der Batteriezustandsinformationen; und
Deaktivieren des Schiffsmodus und elektrisches Verbinden des Systemmoduls (201) und des Batteriepacks (203) miteinander, basierend darauf, dass eine im Systemmodul (201) enthaltene Ein-/Aus-Taste (215) über einen Widerstand (R1) mit einem ersten Pin des Batteriemanagementmoduls (220) verbunden ist,
wobei das Batteriemanagementmodul (220) ein Zellspannungserfassungsmodul (223) umfasst, das dazu konfiguriert ist, eine Zellspannung der Batterie (240) zu erfassen, und über einen positiven Zellspannungs-Pin (305) und einen negativen Zellspannungs-Pin (307) des Batteriemanagementmoduls (220) mit dem Systemmodul (201) verbunden ist,
wobei der erste Pin den positiven Zellspannungs-Pin (305) umfasst.

9. Verfahren nach Anspruch 8, umfassend ferner:
Identifizieren, ob die Batteriezustandsinformationen eine vorbestimmte Bedingung erfüllen; und
Übertragen der Batteriezustandsinformationen oder von Informationen bezüglich des Schiffsmodus an das Systemmodul (201).

10. Verfahren nach Anspruch 9, wobei das Aktivieren des Schiffsmodus und das elektrische Trennen des Systemmoduls (201) und des Batteriepacks (203) voneinander Folgendes umfasst:
wenn die Batteriezustandsinformationen die vorbestimmte Bedingung erfüllen, Aktivieren des Schiffsmodus; und
wenn die Batteriezustandsinformationen die vorbestimmte Bedingung erfüllen, Übertragen eines ersten Steuersignals an ein Schutzbetriebsmodul (230) des Batteriepacks (203), um das Systemmodul (201) und den Batteriepack (203) elektrisch voneinander zu trennen, wobei der erste Pin ferner einen Ein-/Aus-Taste-Erkennungspin (301) oder einen Kommunikations-Pin (303) umfasst und nicht mit der Ein-/Aus-Taste (215) verbunden ist, wenn der Schiffsmodus aktiviert ist,
wobei die vorbestimmte Bedingung eine eingestellte Bedingung umfasst, dass der Zustand der Batterie (240) gleich oder kleiner als ein festgelegter Schwellenwert ist, und
wobei die Batteriezustandsinformationen Informationen umfassen, die einen Zustand mindestens eines von Folgendem angeben: Strom, Spannung und Temperatur.

11. Verfahren nach Anspruch 8, wobei das elektrische Verbinden des Systemmoduls (201) und des Batteriepacks (203) miteinander das Übertragen eines zweiten Steuersignals an ein Schutzbetriebsmodul (230) umfasst, um das Systemmodul (201) und den Batteriepack (203) elektrisch miteinander zu verbinden.

12. Verfahren nach Anspruch 8, wobei das Deaktivieren des Schiffsmodus Folgendes umfasst:
wenn die Ein-/Aus-Taste (215) in einem aktivierten Zustand des Schiffsmodus mit einem Ein-/Aus-Taste-Erkennungspin (301) als dem ersten Pin verbunden ist, Identifizieren eines über den Ein-/Aus-Taste-Erkennungspin (301) eingegebenen Eingangssignals; und
Deaktivieren des Schiffsmodus auf der Grundlage des identifizierten Eingangssignals.

13. Verfahren nach Anspruch 8, wobei das Deaktivieren des Schiffsmodus Folgendes umfasst:
wenn die Ein-/Aus-Taste (215) in einem aktivierten Zustand des Schiffsmodus mit einem Kommunikations-Pin (303) als dem ersten Pin verbunden ist, Erhalten eines Spannungsdifferenzwerts in einem Verbindungspfad zwischen der Ein-/Aus-Taste (215) und dem Kommunikations-Pin (303); und
wenn der Spannungsdifferenzwert gleich oder kleiner als ein festgelegter Schwellenwert ist, Deaktivieren des Schiffsmodus.

14. Verfahren nach Anspruch 8, wobei das Deaktivieren des Schiffsmodus Folgendes umfasst:
wenn die Ein-/Aus-Taste (215) in einem aktivierten Zustand des Schiffsmodus mit dem positiven Zellspannungs-Pin (305) als dem ersten Pin verbunden ist, Erhalten eines Spannungsdifferenzwerts in einem Verbindungspfad zwischen der Ein-/Aus-Taste (215) und dem positiven Zellspannungs-Pin (305); und
wenn der Spannungsdifferenzwert gleich oder kleiner als ein festgelegter Schwellenwert ist, Deaktivieren des Schiffsmodus.

15. Nichtflüchtiges Speichermedium, auf dem ausführbare Befehle gespeichert sind, die so konfiguriert sind, dass sie, wenn sie von mindestens einem Prozessor einer elektronischen Vorrichtung (101) ausgeführt werden, die elektronische Vorrichtung (101) dazu veranlassen, mindestens einen Vorgang durchzuführen,
wobei der mindestens eine Vorgang Folgendes umfasst:
Erhalten von Batteriezustandsinformationen durch Identifizieren eines Zustands einer in einem funktional mit dem Prozessor verbundenen Batteriepack (203) enthaltenen Batterie über ein im Batteriepack (203) enthaltenes Batteriemanagementmodul (220);
Aktivieren eines Schiffsmodus zur Minimierung des in einer Batterie (240) verbrauchten Stroms und elektrisches Trennen eines Systemmoduls (201) und des Batteriepacks (203) voneinander auf der Grundlage der Batteriezustandsinformationen; und
Deaktivieren des Schiffsmodus und elektrisches Verbinden des Systemmoduls (201) und des Batteriepacks (203) miteinander basierend darauf, dass eine im Systemmodul (201) enthaltene Ein-/Aus-Taste (215) über einen Widerstand (R1) mit einem ersten Pin des Batteriemanagementmoduls (220) verbunden ist,
wobei das Batteriemanagementmodul (220) ein Zellspannungserfassungsmodul (223) umfasst, das dazu konfiguriert ist, eine Zellspannung der Batterie (240) zu erfassen, und über einen positiven Zellspannungs-Pin (305) und einen negativen Zellspannungs-Pin (307) des Batteriemanagementmoduls (220) mit dem Systemmodul (201) verbunden ist,
wobei der erste Pin den positiven Zellspannungs-Pin (305) umfasst.

## Revendications

1. Dispositif électronique (101) comprenant :
un module système (201) ; et
un bloc-batterie (203) configuré pour être connecté électriquement au module système (201) ou déconnecté de celui-ci,
dans lequel le bloc-batterie (203) comprend un module de gestion de batterie (220), un module d'opération de protection (230) et une batterie (240), et
dans lequel le module de gestion de batterie (220) est configuré pour :
obtenir des informations d'état de batterie en identifiant un état de la batterie (240),
activer un mode d'expédition pour minimiser la puissance consommée dans la batterie (240) et commander au module d'opération de protection (230) de déconnecter électriquement le module système (201) et le bloc-batterie (203) l'un de l'autre, sur la base des informations d'état de batterie, et
désactiver le mode d'expédition et commander au module d'opération de protection (230) de connecter électriquement le module système (201) et le bloc-batterie (203) l'un à l'autre, sur la base d'une touche d'alimentation (215) incluse dans le module système (201) étant connectée par l'intermédiaire d'une résistance (R1) à une première broche du module de gestion de batterie (220),
dans lequel le module de gestion de batterie (220) comprend un module de détection de tension de cellule (223) configuré pour détecter une tension de cellule de la batterie (240) et connecté au module système (201) par l'intermédiaire d'une broche de tension de cellule positive (305) et d'une broche de tension de cellule négative (307) du module de gestion de batterie (220),
dans lequel la première broche comprend la broche de tension de cellule positive (305).

2. Dispositif électronique (101) selon la revendication 1, dans lequel le module de gestion de batterie (220) comprend :
un module de commande configuré en continu pour identifier l'état de la batterie (240) et commander l'activation ou la désactivation du mode d'expédition.

3. Dispositif électronique (101) selon la revendication 1, dans lequel le module de gestion de batterie (220) est en outre configuré pour, lorsque les informations d'état de batterie satisfont à une condition prédéterminée, activer le mode d'expédition et transmettre un premier signal de commande au module d'opération de protection (230) pour déconnecter électriquement le module système (201) et le bloc-batterie (203) l'un de l'autre,
dans lequel la première broche comprend en outre une broche de reconnaissance de touche d'alimentation (301) ou une broche de communication (303), et n'est pas connectée à la touche d'alimentation (215) lorsque le mode d'expédition est activé,
dans lequel lors de la réception du premier signal de commande provenant du module de gestion de batterie (220), le module d'opération de protection (230) est configuré pour déconnecter le module système (201) d'un module d'alimentation électrique,
dans lequel la condition prédéterminée comprend une condition définie selon laquelle l'état de la batterie (240) est égal ou inférieur à un seuil spécifié, et
dans lequel les informations d'état de batterie comprennent des informations indiquant un état d'au moins un élément parmi le courant, la tension ou la température.

4. Dispositif électronique (101) selon la revendication 1, dans lequel le module de gestion de batterie (220) est en outre configuré pour, lorsque le mode d'expédition est désactivé sur la base d'un signal d'entrée, transmettre un second signal de commande au module d'opération de protection (230) pour connecter électriquement le module système (201) et le bloc-batterie (203) l'un à l'autre, et
dans lequel lors de la réception du second signal de commande provenant du module de gestion de batterie (220), le module d'opération de protection (230) est configuré pour être connecté électriquement à un module d'alimentation électrique du module système (201) afin de fournir de l'énergie de la batterie (240) au module système (201).

5. Dispositif électronique (101) selon la revendication 1, dans lequel le module de gestion de batterie (220) est en outre configuré pour :
lorsque la touche d'alimentation (215) est connectée à une broche de reconnaissance de touche d'alimentation (301) en tant que première broche dans un état activé du mode d'expédition, identifier un signal d'entrée entrant par l'intermédiaire de la broche de reconnaissance de touche d'alimentation (301), et
désactiver le mode d'expédition sur la base du signal d'entrée identifié.

6. Dispositif électronique (101) selon la revendication 1, dans lequel le module de gestion de batterie (220) est en outre configuré pour :
lorsque la touche d'alimentation (215) est connectée à une broche de communication (303) en tant que première broche dans un état activé du mode d'expédition, obtenir une valeur de différence de tension dans un chemin de connexion entre la touche d'alimentation (215) et la broche de communication (303), et
lorsque la valeur de différence de tension est égale ou inférieure à un seuil spécifié, désactiver le mode d'expédition.

7. Dispositif électronique (101) selon la revendication 1, dans lequel le module de gestion de batterie (220) est en outre configuré pour :
lorsque la touche d'alimentation (215) est connectée à une broche de tension de cellule positive (305) en tant que première broche dans un état activé du mode d'expédition, obtenir une valeur de différence de tension dans un chemin de connexion entre la touche d'alimentation (215) et la broche de tension de cellule positive (305), et
lorsque la valeur de différence de tension est égale ou inférieure à un seuil spécifié, désactiver le mode d'expédition.

8. Procédé de fonctionnement d'un dispositif électronique (101) comprenant un module système (201), et un bloc-batterie (203) configuré pour être connecté électriquement au module système (201) ou déconnecté de celui-ci, le procédé comprenant :
obtenir des informations d'état de batterie en identifiant un état d'une batterie incluse dans le bloc-batterie par un module de gestion de batterie (220) inclus dans le bloc-batterie (203) ;
activer un mode d'expédition pour minimiser la puissance consommée dans une batterie (240) et déconnecter électriquement le module système (201) et le bloc-batterie (203) l'un de l'autre, sur la base des informations d'état de batterie ; et
désactiver le mode d'expédition et connecter électriquement le module système (201) et le bloc-batterie (203) l'un à l'autre, sur la base d'une touche d'alimentation (215) incluse dans le module système (201) étant connectée par l'intermédiaire d'une résistance (R1) à une première broche du module de gestion de batterie (220)
dans lequel le module de gestion de batterie (220) comprend un module de détection de tension de cellule (223) configuré pour détecter une tension de cellule de la batterie (240) et connecté au module système (201) par l'intermédiaire d'une broche de tension de cellule positive (305) et d'une broche de tension de cellule négative (307) du module de gestion de batterie (220),
dans lequel la première broche comprend la broche de tension de cellule positive (305).

9. Procédé selon la revendication 8, comprenant en outre :
identifier si les informations d'état de batterie satisfont à une condition prédéterminée ; et
transmettre les informations d'état de batterie ou des informations relatives au mode d'expédition au module système (201).

10. Procédé selon la revendication 9, dans lequel l'activation du mode d'expédition et la déconnexion électrique du module système (201) et du bloc-batterie (203) l'un de l'autre comprennent :
lorsque les informations d'état de batterie satisfont à la condition prédéterminée, activer le mode d'expédition ; et
lorsque les informations d'état de batterie satisfont à la condition prédéterminée, transmettre un premier signal de commande à un module d'opération de protection (230) du bloc-batterie (203) pour déconnecter électriquement le module système (201) et le bloc-batterie (203) l'un de l'autre, dans lequel la première broche comprend en outre une broche de reconnaissance de touche d'alimentation (301) ou une broche de communication (303), et n'est pas connectée à la touche d'alimentation (215) lorsque le mode d'expédition est activé,
dans lequel la condition prédéterminée comprend une condition définie selon laquelle l'état de la batterie (240) est égal ou inférieur à un seuil spécifié, et
dans lequel les informations d'état de batterie comprennent des informations indiquant un état d'au moins un élément parmi le courant, la tension ou la température.

11. Procédé selon la revendication 8, dans lequel la connexion électrique du module système (201) et du bloc-batterie (203) l'un à l'autre comprend la transmission d'un second signal de commande à un module d'opération de protection (230) pour connecter électriquement le module système (201) et le bloc-batterie (203) l'un à l'autre.

12. Procédé selon la revendication 8, dans lequel la désactivation du mode d'expédition comprend :
lorsque la touche d'alimentation (215) est connectée à une broche de reconnaissance de touche d'alimentation (301) en tant que première broche dans un état activé du mode d'expédition, identifier un signal d'entrée entrant par l'intermédiaire de la broche de reconnaissance de touche d'alimentation (301), et
désactiver le mode d'expédition sur la base du signal d'entrée identifié.

13. Procédé selon la revendication 8, dans lequel la désactivation du mode d'expédition comprend :
lorsque la touche d'alimentation (215) est connectée à une broche de communication (303) en tant que première broche dans un état activé du mode d'expédition, obtenir une valeur de différence de tension dans un chemin de connexion entre la touche d'alimentation (215) et la broche de communication (303) ; et
lorsque la valeur de différence de tension est égale ou inférieure à un seuil spécifié, désactiver le mode d'expédition.

14. Procédé selon la revendication 8, dans lequel la désactivation du mode d'expédition comprend :
lorsque la touche d'alimentation (215) est connectée à une broche de tension de cellule positive (305) en tant que première broche dans un état activé du mode d'expédition, obtenir une valeur de différence de tension dans un chemin de connexion entre la touche d'alimentation (215) et la broche de tension de cellule positive (305) ; et
lorsque la valeur de différence de tension est égale ou inférieure à un seuil spécifié, désactiver le mode d'expédition.

15. Support de stockage non transitoire stockant des instructions exécutables configurées pour, lorsqu'elles sont exécutées par au moins un processeur d'un dispositif électronique (101), amener le dispositif électronique (101) à effectuer au moins une opération,
dans lequel l'au moins une opération comprend :
obtenir des informations d'état de batterie en identifiant un état d'une batterie incluse dans un bloc-batterie (203) fonctionnellement connecté au processeur par un module de gestion de batterie (220) inclus dans le bloc-batterie (203) ;
activer un mode d'expédition pour minimiser la puissance consommée dans une batterie (240) et déconnecter électriquement un module système (201) et le bloc-batterie (203) l'un de l'autre, sur la base des informations d'état de batterie ; et
désactiver le mode d'expédition et connecter électriquement le module système (201) et le bloc-batterie (203) l'un à l'autre, sur la base d'une touche d'alimentation (215) incluse dans le module système (201) étant connectée par l'intermédiaire d'une résistance (R1) à une première broche du module de gestion de batterie (220),
dans lequel le module de gestion de batterie (220) comprend un module de détection de tension de cellule (223) configuré pour détecter une tension de cellule de la batterie (240) et connecté au module système (201) par l'intermédiaire d'une broche de tension de cellule positive (305) et d'une broche de tension de cellule négative (307) du module de gestion de batterie (220),
dans lequel la première broche comprend la broche de tension de cellule positive (305).
